Europäisches Patentamt

(19) European Patent Office

Office européen des brevets

(11) Numéro de publication: **0 222 649**
**B1**

(12) **FASCICULE DE BREVET EUROPEEN**

(45) Date de publication du fascicule du brevet:
07.02.90

(21) Numéro de dépôt: 86402295.9

(22) Date de dépôt: **15.10.86**

(51) Int. Cl.⁴: **G01R 33/38**, H01F 7/20

(54) **Perfectionnement à une bobine de gradient pour appareils d'imagerie par résonance magnétique nucléaire.**

(30) Priorité: **18.10.85 FR 8515512**

(43) Date de publication de la demande:
**20.05.87 Bulletin 87/21**

(45) Mention de la délivrance du brevet:
**07.02.90 Bulletin 90/6**

(84) Etats contractants désignés:
**DE GB IT NL**

(56) Documents cités:
**DE-A- 3 133 873**
**FR-A- 2 555 009**

(73) Titulaire: **GENERAL ELECTRIC CGR S.A., 100, rue Camille-Desmoulins, F-92130 Issy les Moulineaux(FR)**

(72) Inventeur: **Prevot, Claude, THOMSON-CSF SCPI 19, avenue de Messine, F-75008 Paris(FR)**

(74) Mandataire: **Ballot, Paul Denis Jacques et al, Cabinet Ballot-Schmit 7, rue le Sueur, F-75116 Paris(FR)**

## Description

La présente invention a pour objet un perfectionnement à une bobine de gradient pour appareils d'imagerie par résonance magnétique nucléaire. Elle trouve plus particulièrement son application dans le domaine médical où l'imagerie par résonance magnétique nucléaire est unanimement reconnue comme aide aux diagnostics. Elle peut bien entendu être mise en oeuvre dans d'autres domaines. Le but de la présente invention est de concourir à la création d'images d'un corps à examiner plus fidèles ainsi que plus précises dans leur résolution.

Un appareil d'imagerie par résonance magnétique nucléaire comporte essentiellement trois types de bobines. Un premier type de bobines (qui peut éventuellement être remplacé par un aimant permanent) a pour objet de créer un champ homogène intense $B_0$ dans un espace prédéterminé. Un deuxième type de bobines, dites radiofréquence, a pour but de soumettre un corps examiné et placé sous l'influence du champ des premières bobines à des séquences d'excitation radiofréquence et de mesurer le signal radiofréquence réémis en retour par des particules du corps. La réponse radiofréquence est une réponse en volume : toutes les particules d'une région du corps soumise à l'examen émettent en même temps leur réponse radiofréquence. Pour créer l'image il est nécessaire de différencier ces réponses. A cette fin, les appareils d'imagerie comportent un troisième type de bobines, dites de gradient, pour superposer au champ intense des composantes de champ supplémentaire. La valeur de ces composantes est une fonction des coordonnées dans l'espace du lieu de leur application. Autrement dit, chaque lieu de l'espace peut être codé par une valeur de champ différent : on exploite dans le signal réémis les modifications qui en découlent. Classiquement il est proposé d'organiser cette différenciation selon trois axes orthogonaux X, Y, Z. Par convention, l'axe Z est colinéaire au champ intense créé par les bobines du premier type.

Les bobines de gradient sont en conséquence affectées à trois familles : celle qui crée un gradient selon X, celle qui crée un gradient selon Y, et celle qui crée un gradient selon Z. L'invention a plus particulièrement, mais pas uniquement, pour objet de proposer une amélioration aux deux premières familles. Un gradient de champ selon X est un champ magnétique dont la distribution de l'amplitude de la composante colinéaire au champ intense Z, dans l'espace, est fonction uniquement de la coordonnée $x_i$ de son lieu d'application. Dans la pratique elle y est même simplement proportionnelle. Ceci signifie que toutes les particules d'un corps à examiner situées dans un plan, parallèle à Y - Z et d'abscisse donnée $x_i$ sont soumises à un champ total $B_0 + G_x \cdot x_i$. Le gradient $G_x$ est la pente de la variation de la composante selon Z du champ supplémentaire apporté par ces bobines de gradient X.

L'acquisition d'une image nécessite au cours de l'application des séquences d'excitation, l'application conjointe de séquences de gradient de champ.

Les séquences de gradient de champ dépendent du procédé d'imagerie mis en oeuvre. Ce procédé peut par exemple être du type 2DFT mis au point par MM.A. KUMAR et R.R. ERNST ou par exemple du type rétroprojection mis au point par M.P.C LAUTERBUR. Quelle que soit la méthode d'imagerie retenue, la principale caractéristique des gradients de champ concerne leur homogénéité. Par homogénéité on entend le respect, avec une tolérance donnée et pour un gradient de champ réel, d'une distribution théorique idéale que l'on voudrait imposer. En effet les inhomogénéités ont pour conséquence de fausser la différenciation que l'on cherche à imposer dans l'espace d'examen et qui est la base même du principe de l'imagerie. De ce point de vue les problèmes d'homogénéité doivent être aussi bien résolus pour les gradients qu'ils peuvent l'être pour le champ homogène intense. Plus les bobines de gradient sont grandes et plus la distribution des champs qu'elles produisent peut être considérée comme homogène. Cette tendance est cependant opposée aux considérations de puissance nécessaire pour produire les gradients de champ. Aussi en général les bobines de gradient sont placées à l'extérieur et le plus près possible des bobines radiofréquence. Celles-ci déterminent en leur intérieur un volume d'examen où est placé le corps.

Il est connu dans l'état de la technique des bobines comportant des conducteurs formés autour d'un cylindre selon un contour dit en selle de cheval. Par exemple le document FR-A 2 555 009 présente de telles bobines. Mais pour y résoudre les problèmes d'homogénéité on y a recours à d'autres bobines du même type placées de la même façon. Cette solution est industriellement trop lourde pour résoudre le problème d'inhomogénéités locales. Les bobines de l'invention peuvent être de ce type mais présentent des particularités propres à résoudre au mieux le double problème de l'homogénéité et de la puissance électrique à mettre en oeuvre pour créer des gradients de champ, à partir de bobines de gradient dont la place est fixée à l'extérieur d'un cylindre donné et correspondant à un tunnel d'accès prévu pour y introduire les corps à examiner. Dans l'invention on a découvert une structure particulière des conducteurs de ces bobines qui permet de résoudre efficacement un problème d'homogénéité sans en augmenter sensiblement la self induction. On montre qu'avec les conducteurs de l'invention, à intensité de champ et à self comparable, des inhomogénéités locales de champ sont réduites.

La présente invention a pour objet une bobine de gradient pour appareil d'imagerie par résonance magnétique nucléaire du type comportant des conducteurs formés chacun autour d'un cylindre, ces conducteurs étant rassemblés en un nombre pair d'arrangements identiques et symétriques par rapport au centre d'un espace prédéterminé d'examen, caractérisée en ce qu'au moins un des conducteurs de chaque arrangement présente au moins un décrochement.

L'invention sera mieux comprise à la lecture de la description qui suit et à l'examen des figures qui l'accompagnent. Elles sont données à titre indicatif et nullement limitatif de l'invention. Sur les figures les mêmes repères désignent les mêmes éléments. Elles montrent :

- Figure 1 : l'allure générale d'une bobine de gradient d'un appareil d'imagerie;
- Figure 2 : une représentation schématique d'un tracé de conducteur mis en oeuvre dans l'invention;
- Figures 3a et 3b : une vue de dessus et une vue en coupe de détails d'une bobine de gradient selon une variante préférée de l'invention;
- figure 4 : une représentation schématique des décrochements de l'invention;
- figures 5 et 6 : des exemples de réalisation de ces décrochements;
- figures 7a et 7b : des résultats de mesure montrant l'amélioration apportée par l'invention.

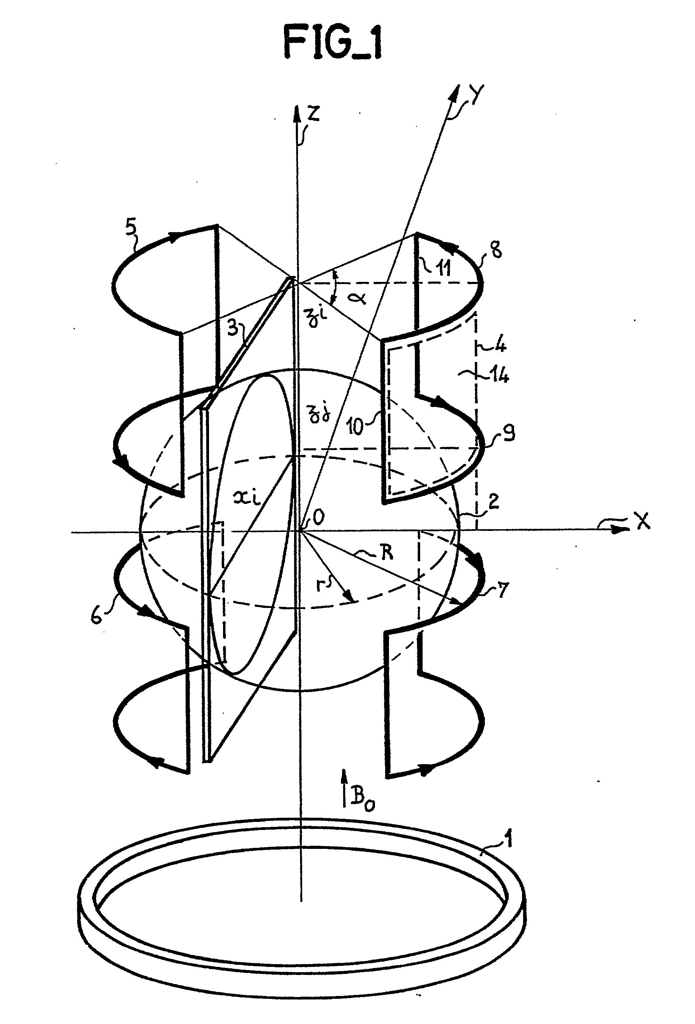

La figure 1 représente une bobine de gradient X pour un appareil d'imagerie par résonance magnétique nucléaire. Cet appareil est symbolisé par une bobine 1 du premier type qui produit un champ intense $B_0$ orienté selon un axe Z. Cet appareil comprend encore des bobines d'excitation radiofréquence non réprésentées. En général ces bobines radiofréquence sont réparties sur un cylindre circulaire centré sur l'axe Z. Elles ont pour objet d'exciter avec une excitation radiofréquence les particules d'un corps à imager qui se trouve, au moins en partie, à l'intérieur d'un espace prédéterminé d'examen repéré par une sphère 2. La bobine de gradient réprésentée est prévue pour produire dans des tranches planes 3 repérées par leur abscisse $x_i$ (c'est-à-dire parallèles au plan Z-Y) des champs magnétiques supplémentaires dont la composante orientée parallèlement à Z est fonction de l'abscisse $x_i$. Cette bobine comporte quatre arrangements de conducteurs notés 4 à 7 et symétriques par rapport au centre O de la sphère 2. Ces arrangements de conducteurs symbolisés ici par le tracé à chaque fois d'un seul conducteur sont également symétriques les uns des autres par rapport à un plan X-Y perpendiculaire à l'orientation du champ intense au centre du volume 2. Les conducteurs sont dessinés selon un contour dit en selle de cheval. Chaque contour comporte deux parties en arceaux formées autour d'un cylindre et reliées entre elles à leurs extrémités par deux parties colinéaires aux génératrices de ce cylindre. Par exemple pour l'arrangement 4 il s'agit des arceaux 8 et 9 et des segments de génératrice 10 et 11. Les conducteurs des arrangements sont bien entendu parcourus par des courants de sens convenable pour produire le gradient recherché. Chaque conducteur d'un arrangement est défini par l'angle d'ouverture $\alpha$ de la portion du cylindre qu'il décrit, et par les altitudes $z_i$ et $z_j$ des extrémités des segments de génératrice qu'il comporte.

La structure représentée sur la figure 1 est connue pour être adaptée à produire des champs supplémentaires dont la composante orientée selon Z varie en fonction de l'abscisse $x_i$. Pour une bobine de gradient produisant un champ supplémentaire dont la composante orientée selon Z varie avec l'ordonnée $y_i$, on réalise un même type de bobine que l'on tourne tout simplement de 90° dans l'espace autour de l'axe Z. Dans une variante préférée, pour obtenir un gradient le plus fort possible, l'altitude $z_j$ de l'arceau le plus près du centre O de la sphère d'examen, est égal sensiblement à 0,29 fois le rayon R du cylindre circulaire qui le porte. De la même façon $z_i$, l'altitude de l'arceau le plus éloigné du centre O, vaut sensiblement 1,27 R, l'angle $\alpha$ le plus favorable valant de l'ordre de 135°. Pour corriger les défauts d'homogénéïté de cette selle théorique dite productrice, on ajoute une autre selle de cheval théorique dite correctrice dont les coordonnées correspondantes $z'_j$, $z'_i$ et $\alpha'$ valent respectivement 0,85 R, 1,50 R, et également 135°.

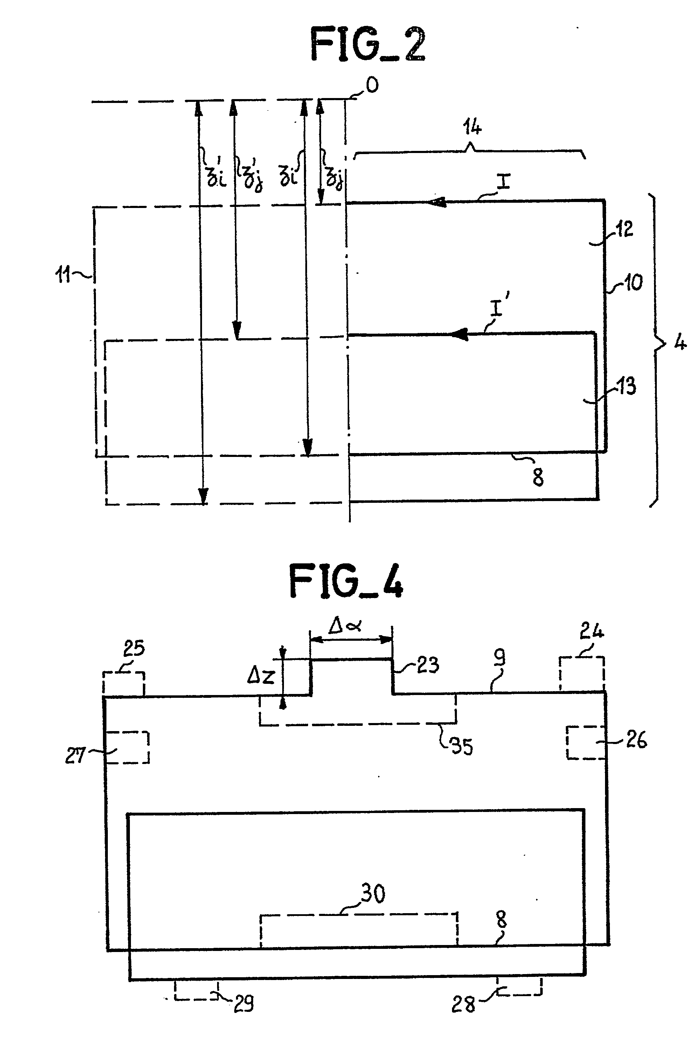

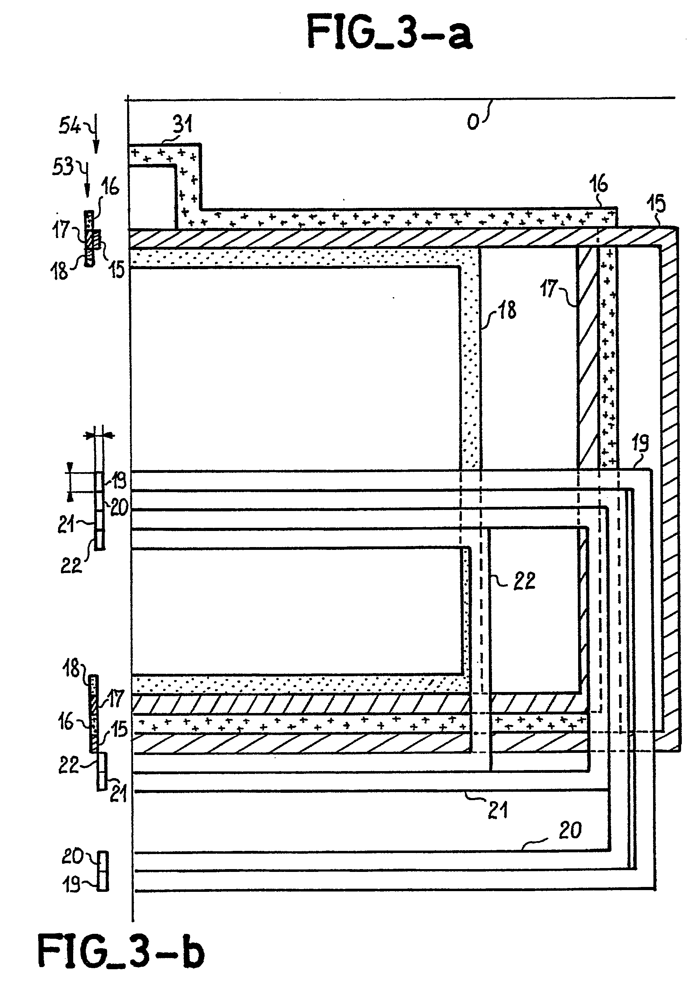

Compte tenu des contraintes de gradient de champ à mettre en oeuvre, typiquement de l'ordre de 0,8 $10^{-4}$ Testa par cm (0,8 Gauss par cm), et des ampères-tours nécessaires, de l'ordre de 800 à 1600 ampères-tours, il est hors de question de prévoir un seul conducteur théorique par selle. Dans un exemple où un courant de l'ordre de 200 ampères est disponible en sortie de moyens d'alimentation en courant, on est conduit à multiplier les conducteurs de chaque arrangement. Les figures 3a et 3b donnent un aperçu de la réalisation de la variante préférée. La selle productrice comporte quatre conducteurs 15 à 18 (en selle de cheval) et la selle correctrice comporte également quatre conducteurs 19 à 22. Chaque conducteur est traversé, pour simplifier, par un même courant I. Cette particularité est mise à profit pour alimenter tous les conducteurs en série. Un tel type de raccordement en série est classique, de même que l'alimentation. Ils ne sont pas représentés ici pour simplifier le dessins. La figure 2 représente une développée d'un huitième d'arrangement côté 14 sur la figure 1. Celui-ci est représenté par ailleurs sur la figure 3a. Cette réprésentation au huitième est préférée elle permet de bien reconnaître les positions respectives des conducteurs. Par symétrie autour d'un plan passant par l'axe Z et par les milieux des secteurs cylindriques $\alpha$ décrits par les selles de cheval on peut déduire le reste de la forme des selles. Sur la figure 2 la représentation au huitième est même dessinée en tirets. Les conducteurs producteurs sont placés plus près du plan 0 dont la trace apparaît en haut de la figure. Les conducteurs correcteurs sont placés plus loin du plan 0 en une nappe superposée 54, à une nappe inférieure 53 qui contient les conducteurs producteurs. La figure 3b montre en coupe les sections des conducteurs choisis plats d'épaisseur $e$ et de largeur $l$. Les ouvertures angulaires et les altitudes $z_j$ et $z_i$ préférées de chacun des conducteurs sont données dans le tableau suivant :

| N° des conducteurs | α | $z_j$ | $z_i$ |
|---|---|---|---|
| 15 | 150°00′ | 0,291 R | 1,332 R |
| 16 | 137°18′ | 0,250 R | 1,291 R |
| 17 | 132°42′ | 0,291 R | 1,250 R |
| 18 | 105°00′ | 0,332 R | 1,209 R |
| 19 | 145°24′ | 0,790 R | 1,621 R |
| 20 | 137°18′ | 0,831 R | 1,580 R |
| 21 | 132°42′ | 0,872 R | 1,415 R |
| 22 | 105°00′ | 0,914 R | 1,374 R |

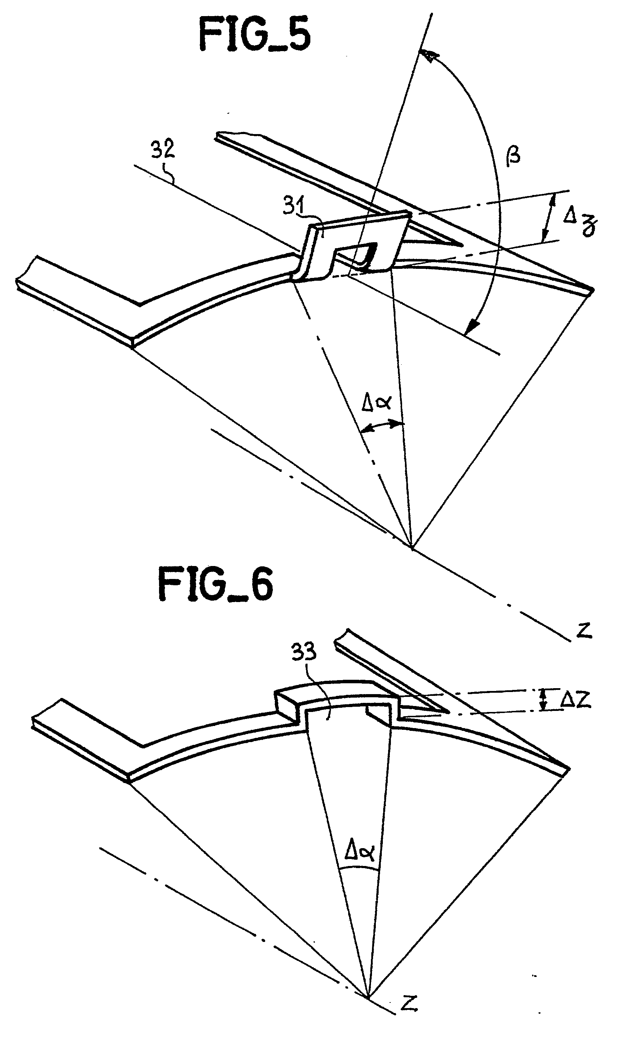

Dans l'invention on a trouvé un moyen original de remédier à des défauts locaux d'inhomogénéité. La figure 4 illustre le principe de l'invention. Il consiste à réaliser, dans les arceaux ou les segments droits des selles de cheval, des décrochements 23, ou 24-25, ou 26-27, ou 28-29, ou 30 etc..., disposés sur au moins un des conducteurs de chacun des arrangements. Les décrochements adoptent une même symétrie que les selles de cheval elles-mêmes. On peut définir pour ces décrochements, de la même façon que pour les selles de cheval, des ouvertures angulaires $\Delta\alpha$ et des variations d'altitude $\Delta z$. D'une manière préférée, $\Delta\alpha$ et $\Delta z$ représentent environ 5 à 10 % du paramètre qu'ils modifient. Ainsi, on résoud des défauts locaux dans la carte du champ sans modifier sensiblement par ailleurs tout le reste de sa distribution. Les modifications de champ ainsi proposées sont réglées par expérimentations successives. Ces expérimentations sont facilitées par une constatation supplémentaire : les décrochements agissent localement sur les champs qui leur sont proches. En reprenant la figure 4, des décrochements 23 ou 35 peuvent être installés sur l'arceau 9 en son milieu. Ils ont principalement pour effet de résoudre des problèmes d'inhomogénéité apparaissant dans le plan zéro (X-Y) particulièrement selon l'axe X. A l'opposé, des décrochements 24-25 ou 26-27 ou 28-29 ou 35, placés soit sur les bords des arceaux soit sur les segments de génératrice des conducteurs, producteurs ou correcteurs, ont principalement pour effet de résoudre des problèmes d'inhomogénéité qui sont distribués principalement sur l'axe Y dans des plans dont l'altitude (selon z) varie comme l'altitude de ces décrochements.

Les figures 5 et 6 montrent des exemples pratiques de réalisation des décrochements selon l'invention. Dans la variante préférée où les conducteurs sont plats, les décrochements peuvent avoir l'allure de languettes telles que 31 placées sur un arceau et dont l'orientation du plan fait avec une génératrice 32 du cylindre un angle $\beta$ donné. L'avantage de cette disposition permet en réglant l'angle $\beta$, en dressant plus ou moins la languette, d'adapter la correction de champ à une valeur prescrite. Dans une approche calculée déterminant les dimensions du décrochement 31, l'angle $\beta$ est pris au départ nul. La figure 6 représente une variante dans lequel le décrochement 33 prend l'allure d'un créneau. La partie d'arceau formant le sommet du créneau se trouve alors dans une nappe supérieure, ou éventuellement inférieure, radialement à la nappe qui porte la plus grande partie du conducteur. La forme du décrochement peut enfin être quelconque, triangulaire ou arrondie, au lieu d'être rectangulaire comme indiqué.

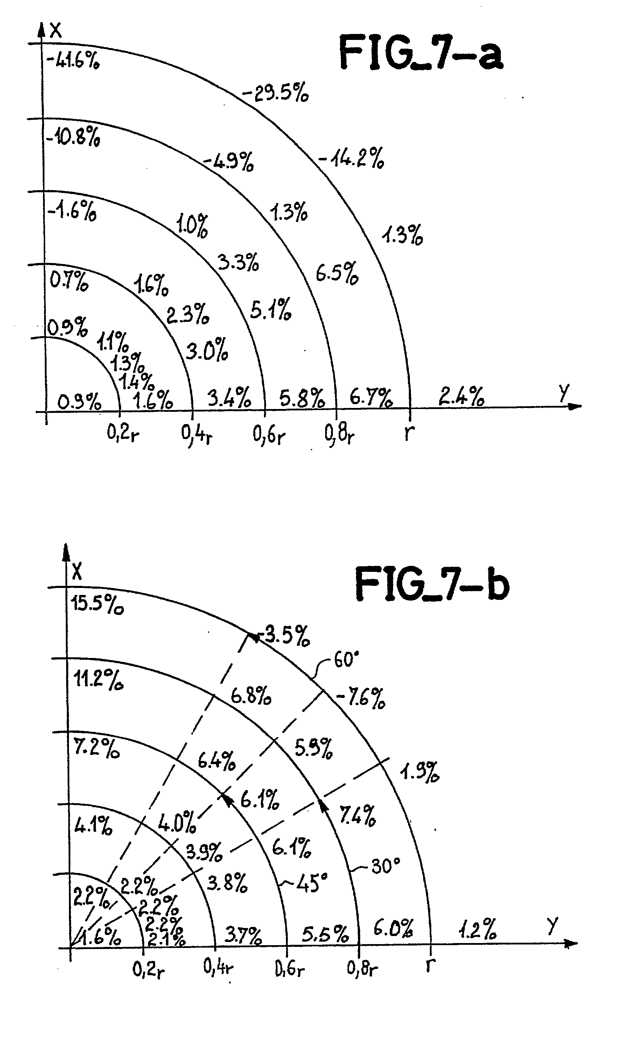

Les figures 7a et 7b montrent dans le plan zéro, l'influence d'un décrochement de type 31 dont l'angle $\beta$ est nul et qui est placé au milieu du conducteur 16 de la figure 3a. La figure 7a donne une répartition en pourcentage dans la sphère 2, du gradient de champ réel par rapport à un gradient théorique à respecter. Deux valeurs singulières apparaissent en $Y = 0$ et $X = r$ ainsi qu'en $X = r . \sqrt{3}/2$ et $Y = 1/2 \, r$. Le rayon $r$ est le rayon de la sphère 2. Les valeurs de - 41,6 % et - 29,5 % sont inacceptables si la tolérance d'homogénéité admise vaut par exemple 15 %. La figure 7b montre ce que devient cet écart après ajout d'un décrochement sur les conducteurs 16 comme indiqué précédemment. L'amplitude de ce décrochement est de l'ordre de 10 % de $z_j$ et $\alpha$. On remarque principalement que les régions où l'homogénéité était inacceptable entrent dans la plage de tolérance. D'autre part la carte d'homogénéité globale a été modifiée mais elle est restée cependant dans les limites acceptables.

**Revendications**

1. Bobine de gradient (4-11) pour appareil (1) d'imagerie par résonance magnétique nucléaire du type comportant des conducteurs (8-11) formés chacun autour d'un cylindre, ces conducteurs de forme régulière allongée étant rassemblés pour chaque bobine en un nombre pair d'arrangements (4-7) identiques et symétriques par rapport au centre (O) d'un espace prédéterminé (2) d'examen, caractérisée en ce qu'au moins un (16) des conducteurs de chaque arrangement présente au moins une partie en décrochement (31) par rapport à l'alignement de ce conducteur.

2. Bobine selon la revendication 1, caractérisée en ce que les conducteurs sont formés chacun selon un contour dit en selle de cheval.

3. Bobine selon la revendication 1 ou 2, caractérisée en ce que le nombre pair d'arrangements vaut 4 et en ce que les arrangements sont également symétriques par rapport à un axe de symétrie (Z) parallèle au cylindre et passant par le centre de l'espace d'examen.

4. Bobine selon les revendications 2 et 3, caractérisée en ce que chaque arrangement présente un plan de symétrie passant par l'axe de symétrie des arrangements et en ce que le ou les décrochements d'un conducteur sont symétriques par rapport à ce plan.

5. Bobine selon la revendication 4, dans laquelle les conducteurs présentent deux parties en arceau (8,9) autour d'un cylindre, reliées par deux parties (10,11) colinéaires aux génératrices de ce cylindre, caractérisée en ce que les décrochements sont placés sur un arceau (9) le plus proche possible de l'espace d'examen pour corriger les distorsions de champ apparaissant dans un plan (X-Y) passant par le centre de l'espace.

6. Bobine selon la revendication 4 ou 5, dans laquelle les conducteurs présentent deux parties en arceau autour d'un cylindre reliées par deux parties colinéaires aux génératrices de ce cylindre, caractérisée en ce que les décrochements sont placés sur un arceau (8) le plus éloigné de l'espace d'examen pour corriger les distorsions de champ apparaissant dans un plan passant par la périphérie de l'espace.

7. Bobine selon l'une quelconque des revendications 4, 5 ou 6, dans laquelle les conducteurs présentent deux parties en arceau autour d'un cylindre reliées par deux parties colinéaires aux génératrices de ce cylindre, caractérisée en ce que les décrochements sont placés sur les conducteurs avec des coordonnées cylindriques analogues aux coordonnées cylindriques des distorsions de champ qu'ils sont en charge de réduire.

8. Bobine selon l'une quelconque des revendications 1 à 7, caractérisée en ce que les décrochements ont une forme en créneau dont l'orientation est perpendiculaire aux génératrices du cylindre qui déterminent la forme du conducteur.

9. Bobine selon l'une quelconque des revendications 1 à 7, caractérisée en ce que les décrochements ont une forme en languette dont le plan fait avec les génératrices du cylindre qui déterminent la forme des conducteurs un angle donné ($\beta$).

10. Bobine selon l'une quelconque des revendications 5 à 9, caractérisée en ce que les décrochements sont placés dans les parties en arceau et présentent par rapport à ces arceaux une longueur relative comprise entre 5 et 10 % environ.

11. Bobine selon l'une quelconque des revendications 5 à 9, caractérisée en ce que les décrochements sont placés dans les parties en arceau et présentent par rapport à l'altitude ($Z_j$) de ces arceaux une hauteur ($\Delta z$) relative comprise entre 5 et 10 % environ.

**Claims**

1. A gradient coil (4–11) for a nuclear magnetic resonance apparatus (1) of the type comprising conductors (8–11) each formed around a cylinder, said conductors of a regular elongated form being assembled for each coil in an even number of identical arrangements (4–7), which are symmetrical in relation to the center (0) of a predetermined examination space (2), characterized in that at least one (16) of the conductors of each arrangement has at least one (16) of the conductors of each arrangement has at least one same part with an discontinuity (31) in relation to the alignment of this conductor.

2. The coil as claimed in claim 1, characterized in that the conductors are each formed with a saddle contour.

3. The coil as claimed in claim 1 or claim 2, characterized in that the even number of arrangements is equal to 4 and in that the arrangements are also symmetrical in relation to an axis of symmetry (Z) parallel to the cylinder and extending through the center of the examination space.

4. The coil as claimed in claims 2 and 3, characterized in that each arrangement has a plane of symmetry extending through the axis of the arrangements and in that the discontinuities of a conductor are symmetrical in relation to this plane.

5. The coil as claimed in claim 4, wherein the conductors have two arc parts (8 and 9) around a cylinder connected by two parts (10 and 11) which are co-linear with respect to the generatrices of this cylinder, characterized in that the discontinuities are placed on an arc (9) of the examination space as close as possible in order to correct the field distortions appearing in a plane (X–Y) extending through the center of the space.

6. The coil as claimed in claim 4 or 5, in which the conductors have two arc parts around a cylinder connected by two parts around colinear with the generatrices of this cylinder, characterized in that the discontinuities are placed on an arc (8) of the examination space at a maximum distance in order to correct the field distortions appearing in a plane passing through the periphery of the space.

7. The coil as claimed in any one of the claims 4, 5 and 6, wherein the conductors have two arc parts around a cylinder connected by two parts colinear with the generatrices of this cylinder, characterized in that the discontinuities are placed in the conductors with cylindrical coordinates analogous to the cylindrical coordinates of the field distortions which they are intended to reduce.

8. The coil as claimed in any one of the claims 1 through 7, characterized in that the discontinuities have the form of a crenellation with an orientation normal to the generatrices of the cylinder which determine the form of the conductor.

9. The coil as claimed in any one of the claims 1 through 7, characterized in that the discontinuities have a tongue form with a plane set at a given angle (8) to the generatrices of the cylinder which determine the form of the conductors.

10. The coil as claimed in any one of the claims 5 through 9, characterized in that the discontinuities are placed in arc parts and in relation to these arcs have a relative length between approximately 5 and approximately 10%.

11. The coil as claimed in any one of the claims 5 through 9, characterized in that the discontinuities are placed in arc parts and in relation to the height ($Z_j$) of these arcs have a relative height ($\Delta z$) between approximately 5 and approximately 10%.

**Patentansprüche**

1. Gradientenspule (4–11) für Gerät zur Bilderzeugung durch magnetische Kernresonanz von dem Typ, der Leiter (8–11) enthält, von denen jeder um einen Zylinder geformt ist, wobei diese Leiter von regelmäßiger länglicher Form für jede Spule in einer geraden Zahl von identischen und symmetrischen Anordnungen (4–7) in bezug auf das Zentrum (0) eines vorbestimmten Untersuchungsraumes (2) zusammengefaßt sind, dadurch gekennzeichnet, daß mindestens einer (16) der Leiter jeder Anordnung mindestens eine Abweichung (31) in bezug auf die Ausrichtung dieses Leiters aufweist.

2. Spule nach Anspruch 1, dadurch gekennzeichnet, daß jeder der Leiter entsprechend einem Umriß, genannt Pferdesattel, geformt ist.

3. Spule nach Anspruch 1 oder 2, dadurch gekennzeichnet, daß die gerade Zahl der Anordnungen 4 beträgt, und daß die Anordnungen gleichzeitig symmetrisch in bezug auf eine Symmetrieachse (Z) parallel zum Zylinder sind und durch das Zentrum des Untersuchungsraumes gehen.

4. Spule nach Anspruch 2 und 3, dadurch gekennzeichnet, daß jede Anordnung eine Symmetrieebene aufweist, die durch die Symmetrieachse der Anordnungen geht, und daß die Abweichung(en) eines Leiters in bezug auf diese Ebene symmetrisch ist (sind).

5. Spule nach Anspruch 4, in der die Leiter zwei Teile in Bogenform (8, 9) um einen Zylinder herum aufweisen, die mit zwei mit den Mantellinien dieses Zylinders gleich ausgerichteten Teilen (10, 11) verbunden sind, dadurch gekennzeichnet, daß die Abweichungen auf einem dem Untersuchungsraum möglichst naheliegenden Bogen (9) angeordnet sind, um Störungen des Feldes zu korrigieren, das in einer Ebene (X–Y) erscheint und das durch das Zentum des Raumes geht.

6. Spule nach Anspruch 4 oder 5, bei welcher die Leiter zwei Teile in Bogenform um einen Zylinder herum aufweisen, die mit zwei gleich ausgerichteten Teilen mit den Mantellinien dieses Zylinders verbunden sind, dadurch gekennzeichnet, daß die Abweichungen auf einem Bogen (8) so weit wie möglich von dem Untersuchungsraum entfernt angeordnet sind, um die Störungen des Feldes zu korrigieren, das in einer Ebene erscheint, die durch den Umfang des Raumes geht.

7. Spule nach einem der Ansprüche 4, 5 oder 6, in der die Leiter zwei Teile in Bogenform um einen Zylinder herum aufweisen, die mit zwei mit den Mantellinien dieses Zylinders gleich ausgerichteten Teilen verbunden sind, dadurch gekennzeichnet, daß die Abweichungen auf den Leitern mit Zylinderkoordinaten analog zu den Zylinderkoordinaten der Feldstörungen angeordnet sind, die sie vermindern sollen.

8. Spule nach einem der Ansprüche 1 bis 7, dadurch gekennzeichnet, daß die Abweichungen eine Scheitelform haben, deren Ausrichtung senkrecht zu den Mantellinien des Zylinders ist, die die Form des Leiters bestimmen.

9. Spule nach einem der Ansprüche 1 bis 7, dadurch gekennzeichnet, daß die Abweichungen eine zungenförmige Form haben, deren Ebene mit den Mantellinien des Zylinders, die die Form der Leiter bestimmen, einen gegebenen Winkel (ß) bildet.

10. Spule nach einem der Ansprüche 5 bis 9, dadurch gekennzeichnet, daß die Abweichungen in den Teilen in Bogenform angeordnet sind und in bezug auf diese Bögen eine relative Länge zwischen ungefähr 5 und 10% haben.

11. Spule nach einem der Ansprüche 5 bis 9, dadurch gekennzeichnet, daß die Abweichungen in den Teilen in Bogenform angeordnet sind und in bezug auf die Höhe (Zj) dieser Bögen eine relative Höhe ($\Delta z$) zwischen ungefähr 5 und 10% aufweisen.

# FIG_1

# FIG_2

# FIG_4

# FIG_3-a

# FIG_3-b

# FIG_5

# FIG_6

FIG_7-a

FIG_7-b